# EUROPEAN PATENT APPLICATION

(11) **EP 4 707 750 A1**
(43) Date of publication of application: **11.03.2026**
(21) Application number: 25200098.9
(22) Date of filing: 04.09.2025
(51) Int. Cl.: G01D 5/353, G01L 1/24, G01R 5/00, G01K 11/3206

(54) **SUBSEA FIBER OPTIC SENSOR ASSEMBLIES AND RELATED METHODS**

(30) Priority: 04.09.2024 US 202463690469 P
(71) Applicant: OneSubsea IP UK Limited, London SW1E 6AJ (GB)
(72) Inventor: LILLESKARE, Katrine Spilde, 5254 Sandsli (NO); ASKELAND, Audun Magne, 5254 Sandsli (NO); NESHEIM, Tom Inge, 5254 Sandsli (NO)
(74) Representative: Schlumberger Intellectual Property Department

(57) **Abstract**

An embodiment of a system includes a canister that defines a chamber and that is configured to maintain the chamber at a controlled pressure in a subsea environment. In addition, the system includes an electrical connector defined on the canister that is configured to be electrically coupled to a subsea device. Further, the system includes a fiber optic sensing element positioned in the chamber and coupled to the electrical connector such that the fiber optic sensing element is configured to detect a voltage or a current of the subsea device via the electrical connector.

## Description

### CROSS-REFERENCE TO RELATED APPLICATIONS

This application claims the benefit of and priority to U.S. Provisional Patent Application No. 63/690,469, filed September 4, 2024, and entitled "Subsea Measurement System," the entire contents of which are incorporated herein by reference.

### BACKGROUND

Embodiments disclosed herein generally relate to subsea sensor assembles, and particularly to fiber optic sensor assemblies for subsea systems and related methods.

Subsea systems may include equipment or devices that are positioned in the subsea environment (such as on the seafloor). For instance, some subsea systems may include subsea devices or subsystems that receive, generate, output, control, adjust, utilize, etc. electrical power during operations. It is typically desirable to monitor one or more operating parameters of such subsea devices. Thus, an operator of a subsea system may utilize sensors that measure or detect various parameters related to the operation of the subsea components during operations.

### SUMMARY

Some embodiments disclosed herein are directed to a system including a canister that defines a chamber and that is configured to maintain the chamber at a controlled pressure in a subsea environment. In addition, the system includes an electrical connector defined on the canister that is configured to be electrically coupled to a subsea device. Further, the system includes a fiber optic sensing element positioned in the chamber and coupled to the electrical connector such that the fiber optic sensing element is configured to detect a voltage or a current of the subsea device via the electrical connector.

Some embodiments disclosed herein are directed to a method including lowering a canister below a sea surface and into a subsea environment, wherein the canister defines a chamber that is maintained at a controlled pressure. In addition, the method includes connecting an electrical connector defined on the canister to a subsea device. Further, the method includes detecting a voltage or a current of the subsea device with a fiber optic sensing element that is positioned in the chamber.

Some embodiments disclosed herein are directed to a system including a canister that defines a chamber and that is configured to maintain the chamber at a controlled pressure in a subsea environment. In addition, the system includes one or more connectors defined on the canister that are configured to be coupled to a subsea device. Further, the system includes one or more fiber optic sensing elements positioned in the chamber and coupled to the one or more connectors such that the one or more fiber optic sensing elements are configured to detect a plurality of electrical parameters of the subsea device via the one or more connectors.

### BRIEF DESCRIPTION OF THE DRAWINGS

For a detailed description of various exemplary embodiments, reference will now be made to the accompanying drawings in which:
FIG. 1 is schematic diagram of a subsea system that includes a subsea fiber optic sensor assembly according to some embodiments disclosed herein;
FIG. 2 is a schematic diagram of the subsea system that includes another fiber optic sensor assembly according to some embodiments disclosed herein;
FIG. 3 is a schematic diagram of an offshore wind turbine system that includes one or more fiber optic sensor assemblies according to some embodiments disclosed herein;
FIG. 4 is a schematic diagram of a fiber optic sensor assembly that may be used in the system of FIG. 3 according to some embodiments disclosed herein; and
FIG. 5 is a flow diagram of a method of measuring one or more parameters by use of a subsea fiber optic sensor assembly according to some embodiments disclosed herein.

### DETAILED DESCRIPTION

A subsea system may include equipment or devices that are configured to receive, generate, output, control, adjust, utilize, etc. electrical power during operations. Operators of such subsea systems may utilize sensors to measure or detect one or more operating parameters of the subsea devices. However, such sensors may typically also use electrical power to operate. As a result, the inclusion of these additional sensors may involve the installation of additional electrical infrastructure, which adds complexity, expense, and potential failure points to the subsea system.

Accordingly, embodiments disclosed herein are directed to subsea fiber optic sensor assemblies that are configured to passively measure or detect one or more operating parameters of a subsea device during operations. In some embodiments, the fiber optic sensors assemblies may be configured to measure the one or more operating parameters of the subsea device by use of light signals and reflections thereof. In some embodiments, the fiber optic measurement assemblies may include one or more fiber Bragg gratings (FBGs) that are configured to sense the one or more operating parameters. However, such FBGs may be sensitive to forces that change a distance between the gratings (such as pressure, strain, temperature, etc.). Some of these forces may be a feature of the subsea environment in which the subsea fiber optic sensors assemblies are deployed within. Accordingly, embodiments of the subsea fiber optic sensors assemblies disclosed herein may be configured to account for the effects of such environmental forces so that accurate measurements may be obtained during operations. Thus, through use of the embodiments disclosed herein, one or more operating parameters of a subsea device may be accurately and passively measured during operations.

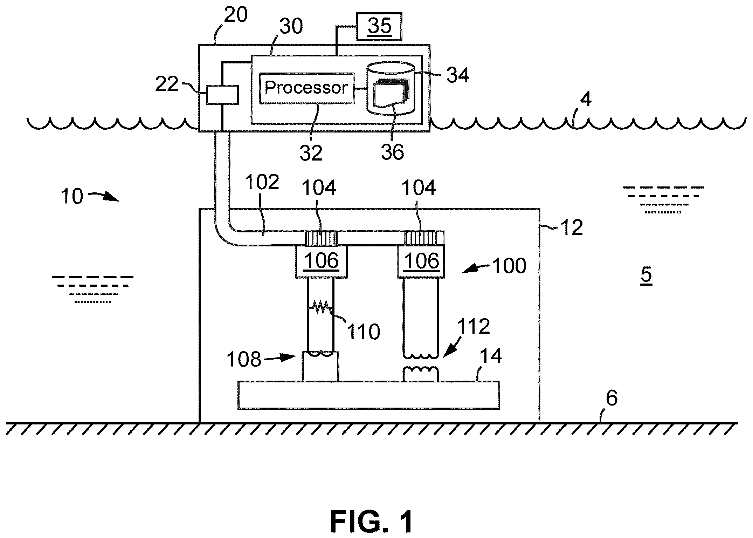

FIG. 1 shows a system 10 including a subsea fiber optic sensor assembly 100 according to some embodiments. The system 10 may include a device 12 that is positioned in a subsea environment 5 that is beneath the sea surface 4 and on or above the seafloor 6. Thus, the device 12 may be referred to herein as a "subsea device." The device 12 may comprise one or more electrical components 14 that are configured to provide, enhance, or facilitate one or more functions of the device 12 during operations. For instance, the one or more electrical components 14 (which are collectively illustrated by a single box in FIG. 1 in order to simplify the drawings) may include wiring, circuits, controllers, transformers, windings, switches, sensors, actuators, switchboards, circuit boards, other electronic components, or combinations thereof. In some embodiments, the device 12 comprises a subsea power substation or electrical transformer and the electrical component(s) 14 may comprise the various electronic components for facilitating the function of such a device.

The subsea fiber optic sensor assembly 100 (or "sensor assembly 100") may include a fiber optic sensing element 102. The fiber optic sensing element 102 may comprise a fiber optic cable (or multiple fiber optic cables), fiber optic connectors, other fiber optic elements, or combinations thereof. In the embodiment illustrated in FIG. 1, the fiber optic sensing element 102 comprises a fiber optic cable that extends into (or proximate to) a housing of the device 12.

One or more FBGs 104 are defined on or coupled to the fiber optic sensing element 102. In some embodiments, the FBGs 104 may comprise dielectric mirrors that are spliced into the fiber optic sensing element 102. When the FBGs 104 are illuminated, they reflect light within a defined wavelength bandwidth. In addition, strain (such as expansive or compressive strain) that is applied to the FBGs 104 may change the wavelength of reflected light. The reflected light may be referred to herein as a "response reflection." These changes in the wavelength can be measured to determine the strain that is being applied to the FBG 104 (or a value indicative thereof as described herein). In addition, the FBGs 104 may also be sensitive to temperature in that the temperature of the FBG may also induce a strain thereon, which again can be measured via the wavelength of response reflection as previously described. This measured strain can then be converted back to the temperature applied to the FBG 104 during operations. Further, because a FBG is pressure sensitive, in some embodiments, one or more of the FBGs 104 (or one or more FBGs 104 on another sensor assembly 100) may be configured to measure a pressure, such as a differential pressure applied to a particular component, chamber, or other portion of the device 12 (or another device).

In some embodiments, the fiber optic element 102 may comprise a single fiber optic element and the FBGs 104 may be coupled to and spaced along the single fiber optic element. In at least some of these embodiments, the FBGs 104 may be configured to reflect different wavelengths of light so that each FBG 104 may be separately interrogated and collected from along the single fiber optic element 102 during operations. The use of separate wavelengths of light to interrogate the FBGs 104 is referred to as wavelength division multiplexing (WBM). In some embodiments, the fiber optic element 102 may comprise a plurality of fiber optic elements, and each of the fiber optic elements is coupled to a corresponding one of the FBGs 104. Thus, the FBGs 104 can be separately interrogated and collected from by routing a light signal through the corresponding fiber optic sensing element. In some embodiments, even if a single fiber optic sensing element 102 is utilized, the single fiber optic sensing element may be coupled to a suitable controller (e.g., controller 30 described in more detail herein) with a plurality (such as two) fiber optic cables in order to provide redundancy to the connection in case of damage, wear, or other loss of connectivity.

In the embodiment illustrated in FIG. 1, the sensor assembly 100 may be specifically configured to measure an electrical current and a voltage associated with the electrical components 14 (or at least some of the electrical components 14). Specifically, the sensor assembly 100 may include or be coupled to a current transformer 108 that is electrically coupled to the electrical components 14 (or at least some of the electrical components 14). During operations, an electrical current in the electrical components 14 may induce a corresponding (such as a proportional) electrical current (such as an alternating current - AC) in the current transformer 108. A resistor 110 (which may be referred to as a "burden resistor") may be coupled to or included on the current transformer 108 to convert the induced electrical current to a voltage.

In addition, the fiber optic sensor assembly 100 may include or be coupled to a voltage transformer 112 that is also electrically coupled to the electrical components 14 (or at least some of the electrical components 14). During operations, a voltage in the electrical components 14 may induce a corresponding (such as a proportional) voltage in the voltage transformer 112.

Further, the sensor assembly 100 may include one or more piezoelectric devices 106. Specifically, a first piezoelectric device 106 may be coupled to (such as between) the current transformer 108 and a first of the FBGs 104, and a second piezoelectric device 106 may be coupled to (such as between) the voltage transformer 112 and a second of the FBGs 104. The piezoelectric elements may be configured to expand and compress (or contract) in response to an applied voltage. Thus, during operations, a voltage that is conducted to the piezoelectric devices 106 (such as via the current transformer 108 or voltage transformer 112) may cause the piezoelectric devices 106 to expand or contract and therefore induce or adjust a strain that is applied to the FBGs 104. Thus, in this manner, the fiber optic sensing element 102 (which includes the FBGs 104) may be configured to detect a voltage or a current of the device 12 and particularly of the electrical components 14 of the device 12.

A controller 30 may be coupled (such as communicatively coupled) to the sensor assembly 100. In some embodiments, the controller 30 may be configured to control one or more aspects of the sensor assembly 100 during operations. For instance, the controller 30 may be configured to interrogate the sensor assembly 100, receive response reflection(s) back from the sensor assembly 100, and interpret the response reflection(s) in order to determine the underlying measured or detected parameter of the electrical components 14 as previously described (e.g., such as a voltage, current, temperature, etc.).

The controller 30 may be remotely located relative to the device 12 and the sensor assembly 100. More specifically, in some embodiments, the controller 30 may be located outside of the subsea environment 5. For example, in some embodiments, the controller 30 may be located on a support structure 20 that is positioned at the sea surface 4. The support structure 20 may comprise any suitable vessel or other structure such as a platform, a floating production, storage, and offloading unit (FPSO). Alternatively, in some embodiments, the controller 30 may be located on or in a shore-based facility.

In some embodiments, the controller 30 may comprise a computing device or collection of computing devices that are communicatively coupled to one another. Generally speaking, the controller 30 may comprise a processor 32 and a memory 34.

The processor 32 may comprise any suitable processing device, such as a microcontroller, central processing unit (CPU), graphics processing unit (GPU), timing controller (TCON), scaler unit. The processor 32 executes computer-readable instructions 36 stored on memory 34, thereby causing the processor 32 to perform some or all of the actions attributed herein to the controller 30. In general, processor 32 fetches, decodes, and executes instructions. In addition, processor 32 may also perform other actions, such as, making determinations, detecting conditions or values, etc., and communicating signals. If processor 32 (or more broadly, the controller 30) assists another component in performing a function, then processor 32 (or more broadly, the controller 30) may be said to cause the component to perform the function.

The memory 34 may comprise volatile storage (e.g., random access memory (RAM)), non-volatile storage (e.g., flash storage, read-only memory (ROM), etc.), or combinations of both volatile and non-volatile storage. Data read or written by the processor 32 when executing computer-readable instructions 36 can also be stored on memory 34. In addition, data collected by the sensor assembly 100 may also be stored on memory 34. Memory 34 may comprise "non-transitory computer-readable medium," where the term "non-transitory" does not encompass transitory propagating signals.

As used herein, "a processor," "at least one processor," or "one or more processors" generally refer to a single processor configured to perform one or multiple operations or multiple processors configured to collectively perform one or more operations. In the case of multiple processors, performance of the one or more operations could be divided amongst different processors, though one processor may perform multiple operations, and multiple processors could collectively perform a single operation. Similarly, "a memory," "at least one memory," or "one or more memories" generally refer to a single memory configured to store data and/or instructions or multiple memories configured to collectively store data and/or instructions.

The controller 30 may comprise a dedicated controller for controlling the sensor assembly 100. Alternatively, the controller 30 may be included as part of a general or master controller for the system 10. In one or more embodiments, the controller 30 may be embodied as a single unit or device. Alternatively, in one or more embodiments, the controller 30 may be embodied as a plurality of devices that are communicatively coupled to one another and potentially remotely spaced from one another.

The controller 30 may include or be coupled to a suitable human-machine interface (HMI) 35 that may allow personnel to interact with the controller 30. For instance, the HMI 35 may be used to communicate outputs (such as measurement outputs) to a user and/or to receive inputs from the user during operations. In some embodiments, the HMI 35 may comprise a keyboard, display (including a touch sensitive display), mouse, speaker, other interface devices, or combinations thereof.

The controller 30 may be coupled to (or may include) a suitable interrogator 22 that is further coupled to the fiber optic sensing element 102. For instance, the fiber optic sensing element 102, as one or more fiber optic cables or lines, may be extended from the device 12 to the sea surface 4, where it is coupled (via suitable connectors or systems) to the interrogator 22. The interrogator 22 may comprise any suitable device, system, assembly, etc. that is configured to generate light signals that are directed into the fiber optic sensing element 102 during operation. In addition, the interrogator 22 (or the controller 30 or other devices coupled thereto) may be configured to receive the response reflection(s) back from the FBGs 104 of the fiber optic sensing element 102 that then may be analyzed (e.g., by the controller 30) to determine the underling parameter(s) as previously described (such as voltage, current, temperature, etc.).

During operations, the controller 30 may direct the interrogator 22 to output a desired interrogation signal to the fiber optic sensing element 102. The interrogation signal may be of a particular wavelength of light that is configured to reflect within a desired one of the FBGs 104. For instance, the interrogation signal may be configured to reflect off of the FBG 104 that is coupled to the current transformer 108 via the corresponding piezoelectric device 106. The piezoelectric device 106 may induce a strain on the FBG 104 that is characteristic or indicative of a current that is induced in the current transformer 108 by the electrical components 14 as previously described. This strain may alter the wavelength of the response reflection that is the received by the controller 30 (such as directly, or via the interrogator 22 and/or other device or system). The controller 30 may be configured to determine the underling current that is being induced in the current transformer 108 based on one or more parameters (such as the wavelength) of the response reflection.

A similar procedure may be performed to determine the voltage that is induced in the voltage transformer 112 during operations. However, in this case, the controller 30 may direct the interrogator 22 to output a desired interrogation signal in a different wavelength - that is, a wavelength that is configured to be reflected by the FBG 104 coupled to the voltage transformer 112 via the corresponding piezoelectric device 106.

In some embodiments, the fiber optic sensing element 102 and particularly the FBGs 104 may be exposed to the pressure of the subsea environment 5. This environmental pressure may induce additional strain on the FBGs 104 that may frustrate the accuracy of the strain-based measurements previously described. As a result, in some embodiments, the controller 30 may be configured to apply a calibration offset to the measurements that are received via the sensor assembly 100. In some embodiments, the calibration offset may be determined based on the pressure of the subsea environment 5 that surrounds the sensor assembly 100. Because the pressure of the subsea environment 5 is directly related to the depth (that is, the depth below the sea surface 4), the calibration offset may also be a function of the depth of the sensor assembly 100. Thus, by applying the calibration offset, the controller 30 may accurately determine the one or more parameters that are measured or detected by the sensor assembly 100 (such as a current or voltage of the electrical components 14) as previously described.

In some embodiments, the calibration offset may be predetermined via laboratory or other controlled testing. For instance, a pressurized tank may be used to determine the appropriate calibration offset for different ambient pressures, and these predetermined offset calibrations may then be utilized (e.g., by the controller 30) to account for the strain on the FBGs 104 due to the pressure of the subsea environment 5 as previously described.

In some embodiments, the fiber optic sensing element 102 may include at least one FBG 104 that is configured to measure or detect a temperature of or associated with the electrical components 14, such as an electrical winding, connection, or other device or structure of the electrical component(s) 14. For instance, as previously described, the device 12 may comprise an electrical transformer, which may include transformer oil. In some embodiments, the at least one FBG 104 of the fiber optic sensing element may be positioned in or otherwise in thermal contact with the transformer oil of the device 12, so that the thermal energy of the transformer oil is transferred to FBG 104 to thereby cause a resulting strain therein. Thus, a FBG 104 that is configured to measure a temperature of component, environment, etc. may not include or be coupled to a piezoelectric device (such as the piezoelectric devices 106 previously described). During operations, the controller 30 may interpret response reflection from the FBG 104 to determine the underlying temperature of the transformer oil based on one or more parameters (such as wavelength) of the response reflection as previously described.

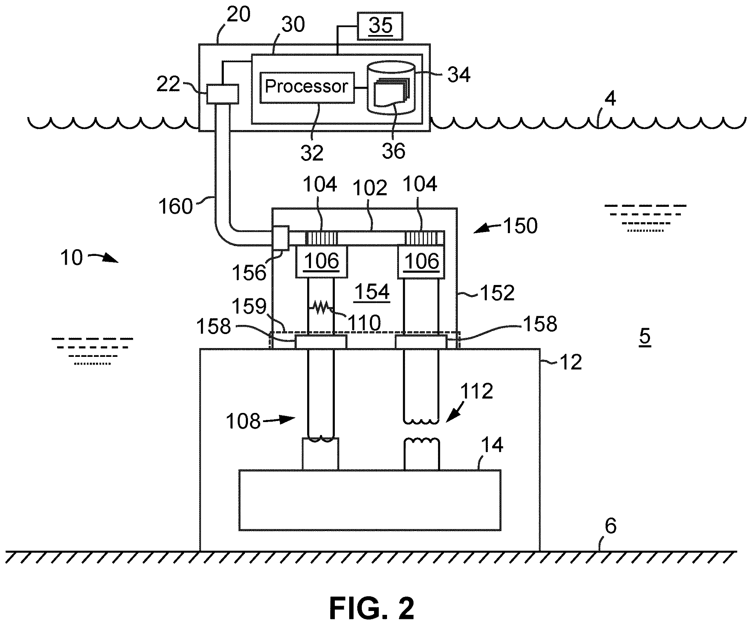

FIG. 2 shows the system 10 of FIG. 1 with another subsea fiber optic sensor assembly 150 according to some embodiments. The fiber optic sensor assembly 150 (or "sensor assembly 150") may share a number of components with the sensor assembly 100 previously described (FIG. 1). Thus, when describing the sensor assembly 150, the same reference numbers are used to refer to components of sensor assembly 150 that are shared with the sensor assembly 100. In addition, the following description will focus on the features of the sensor assembly 150 that are different from the sensor assembly 100 (FIG. 1).

In particular, the sensor assembly 150 may include the fiber optic sensing element 102, FBG(s) 104, piezoelectric devices 106, and transformers 108, 112 as previously described for the sensor assembly 100. However, the sensor assembly 150 may additionally include a canister 152 that is configured to enclose and contain one or more of the components of the sensor assembly 150 (such as fiber optic sensing element 102, FBGs 104, piezoelectric devices 106, etc.). The canister 152 may be configured to shield or protect the sensor assembly 150 (or at least one or more components thereof) from the pressure of the subsea environment 5.

The canister 152 may comprise a pressure vessel (such as a tank, bottle, housing, or other enclosure) that defines a chamber 154 therein. The canister 152 may be configured to maintain a controlled pressure in the chamber 154 that may be less than the pressure of the subsea environment 5. For instance, in some embodiments, the chamber 154 may be configured to maintain a controlled pressure of about 1 standard atmosphere (atm) so as to allow the FBGs 104 to react to induced strain from the piezoelectric devise 106 in a similar manner to that seen on the sea surface or on-shore. Thus, by maintaining the chamber 154 at about 1 atm pressure, the sensor assembly 150 may be calibrated outside of the subsea environment under ambient conditions, prior to installing the sensor assembly 150 in the subsea environment 5.

In some embodiments, the chamber 154 may be filled with air. However, because air may expand or contract due to differences in temperature, in some embodiments, the chamber 154 may be filled with a suitable gas, liquid, or other medium that may be less pressure sensitive to changes in ambient temperature. For instance, in some embodiments, the chamber 154 may be filled with nitrogen (N₂).

In some embodiments, the fiber optic sensing element 102 may be coupled to the controller 30 via a fiber optic cable 160 that extends from the canister 152 to the sea surface 4. The fiber optic cable 160 may be coupled to the fiber optic sensing element 102 via a fiber connector 156 that is defined on a wall or other surface of the canister 152. The fiber connector 156 may comprise any suitable fiber optic connector that may couple the fiber optic cable 160 to the fiber optic sensing element 102 so that light signals may pass therethrough with no or minimal signal degradation. In some embodiments, the fiber optic sensing element 102 may comprise a fiber optic cable that extends through the wall of the canister 152 and up toward the sea surface 4, so that the separate fiber connector 156 and fiber optic cable 160 may be omitted.

In some embodiments, each of the FBGs 104 may be coupled to the electrical component(s) 14 of the device 12 via electrical connectors 158 that are defined on the canister 152 (such on a wall or other surface). The electrical connectors 158 may comprise any suitable connector or other interface that is configured to electrically couple two components to one another. For instance, in some embodiments, the electrical connectors 158 may comprise wet-mateable electrical connectors that are configured to establish an electrical connection between the sensor assembly 150 and the electrical component(s) 14 in the subsea environment 5. Without being limited to this or any other theory, the use of so-called wet-mateable (or other readily disengage-able) connectors for the electrical connectors 158 may allow the canister 152 to be disconnected from the device 12 and pulled or retrieved to the sea surface 4 (such as in the event of a failure of the sensor assembly 100). In some embodiments, the fiber connector 156 may also comprise a wet-mateable connector that is configured to be connected or disconnected in the subsea environment 5.

In some embodiments, the electrical connectors 158 may be included or integrated into a mechanical connection between the canister 152 and an outer surface, support, or other structure of (or associated with) the device 12. Specifically, in some embodiments, the electrical connectors 158 may be included or integrated into one or more bulkhead connectors 159 that are configured to secure the canister 152 to the device 12 (or some surface, support, or other structure of or associated therewith).

As shown in FIG. 2, in some embodiments at least a portion of the transformers 108, 112 may be positioned or incorporated into the device 12, or may at least be positioned outside of the canister 152. Specifically, in some embodiments, the transformers 108, 112 may be coupled between the electrical connectors 158 and the electrical component(s) 14, and potentially within a body, housing, frame, etc. of the device 12. Without being limited to this or any other theory, minimizing the number of components within the canister 152 may allow the size of the chamber 154 to be reduced. A smaller chamber 154 may be more easily maintained at the lower pressure (e.g., about 1 atm in some embodiments as previously described) in the substantially higher pressure of the subsea environment 5. However, it should be appreciated that the transformers 108, 112 (or at least some components thereof) may be positioned in the chamber 154 along with the fiber optic sensing element 102 and FBGs 104. For instance, as shown in FIG. 2, the burden resistor 110 of the current transformer 108 is positioned within the chamber 154, and electrically coupled between the corresponding electrical connector 158 and piezoelectric device 106.

Operations with the sensor assembly 150 are substantially the same as that previously described for the sensor assembly 100, so this description will not be fully repeated in the interests of brevity. However, during operations, because the sensor assembly 150 includes the canister 152, the FBGs 104 do not experience increased strain due to the increased pressures of the subsea environment 5. As a result, the controller 30 may not apply a calibration offset to the measurements that are received via the sensor assembly 150, such as was described for the sensor assembly 100 (FIG. 1).

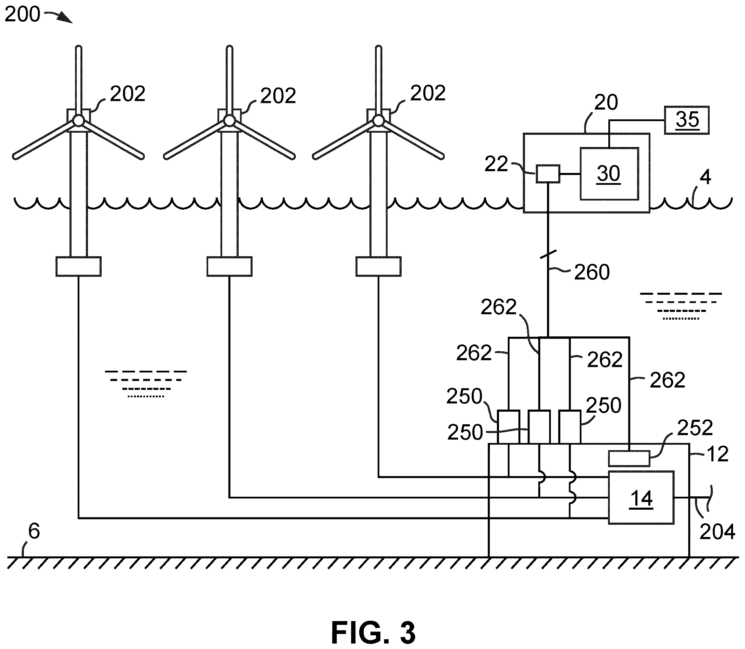

Referring now to FIG. 3, an offshore wind turbine system 200 is shown that includes one or more fiber optic sensor assemblies 250, 252 according to some embodiments. The offshore wind turbine system 200 ("system 200") may include one or more (such as one or a plurality of) offshore wind turbines 202 that are configured to generate electrical power based on wind flowing across and/or over the sea surface 4. The offshore wind turbines 202 ("turbines 202") may each be electrically coupled to the subsea device 12. As shown in FIG. 3, the device 12 may be configured as a subsea electrical transformer or electrical substation that is configured to receive (and potentially transform or convert) electrical power generated by the turbines 202. For instance, the electrical component(s) 14 of the device 12 may be configured to convert the electrical power generated by the turbines 202 for delivery to a transmission line 204 (or other suitable infrastructure or location).

In addition, as shown in FIG. 3, the system 200 may include one or more (such as a plurality of) fiber optic sensor assemblies 250, 252 that are configured to measure or detect one or more parameters of (or associated with) the device 12, turbines 202, etc. The fiber optic sensor assemblies 250, 252 (or "sensor assemblies 250, 252") may be configured as one or more of the sensor assemblies 100, 150 (FIGS. 1, 2, respectively) as previously described. For instance, the sensor assemblies 250 may be configured as the sensor assembly 150, and therefore include canisters 152 that define chambers 154 (FIG. 2) that are maintained at a controlled pressure as previously described. However, it should be appreciated that one or more of the sensor assemblies 250 may be configured as the sensor assembly 100 (FIG. 1), previously described.

Each of the sensor assemblies 250 may be electrically coupled to the electrical component(s) 14 of the device 12. More specifically, each of the sensor assemblies 250 may be electrically coupled to a corresponding one of the turbines 202 and the electrical component(s) 14. During operations, the sensor assemblies 250 may be configured to measure or detect one or more parameters associated with the electrical power generated by the turbines 202, such as a current, voltage, temperature, etc. The sensor assemblies 250 may be configured to measure or detect the one or more parameters in the manner previously described above for the sensor assembly 150 (or the sensor assembly 100) as previously described.

While the sensor assemblies 250 are shown to be connected to the device 12, it should be appreciated that one or more of the sensor assemblies 250 may be coupled to other components or otherwise alternately positioned in the system 200 in some embodiments. For example, in some embodiments, one or more of the sensor assemblies 250 may be coupled to corresponding ones of the turbines 202, or may be independently placed in the subsea environment 5, adjacent to the turbines 202 and/or the device 12.

In some embodiments, some sensor assemblies 250 may be couped to the device 12 as shown in FIG. 3, and additional sensor assemblies 250 may be included that are coupled to the turbines 202 (or between the turbines 202 and device as previously described). Without being limited to this or any other theory, the inclusion of additional and/or alternatively placed sensor assemblies 250 may allow the sensor assemblies to measure or detect one or more parameters (such as current, voltage, temperature, etc.) at various points in the system 200. These additional measurements may allow for better analysis of the electrical performance of the system 200 and may allow personnel (or controllers or other computing devices) to determine a location and nature of a detected error (such as an electrical short, disconnection, etc.) within the system 200 during operations.

In addition, the system 200 may include one or more additional sensor assemblies 252 that are specifically configured to measure a temperature of one or more components of the system 200. More particularly, a sensor assembly 252 may be couped to the device 12 so that the sensor assembly 252 may be configured to measure or detect a temperature associated with the device 12. When the device 12 is configured as a subsea electrical transformer as previously described, the device 12 may include transformer oil for electrically insulating and cooling one or more internal components thereof during operations. In some embodiments, the sensor assembly 252 may be configured to measure or detect a temperature of the transformer oil during operations.

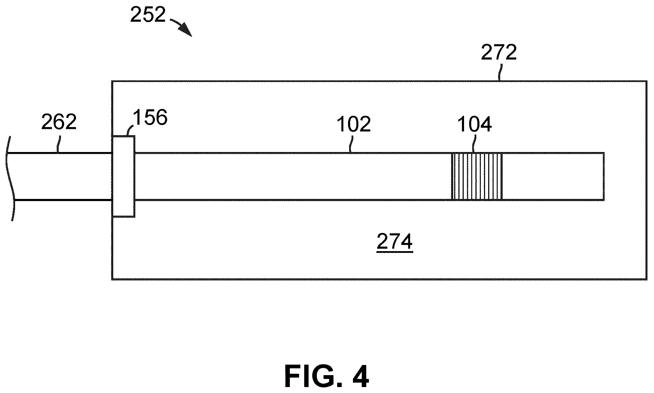

For instance, with reference to FIG. 4, the sensor assembly 252 may include a canister 272 that defines a pressure-controlled chamber 274 as previously described for the canister 152 of sensor assembly 150 (FIG. 2). As is previously described for the chamber 154 of the canister 152 in FIG. 2, the chamber 274 may be maintained at about 1 atm; however, other pressures are contemplated.

In addition, the sensor assembly 252 includes a fiber optic sensor element 102 and FBG 104 positioned in the chamber 274 in a similar manner that described for the sensor assembly 150 (FIG. 2). The fiber optic sensing element 102 may be coupled to a fiber optic cable 262 for communication with other systems or devices (such as controller 30) via a fiber connector 156 as previously described for the sensor assembly 150 (FIG. 2). In some embodiments, the fiber optic sensing element 102 may extend through the wall of the canister 272 as previously described for embodiments of the sensor assembly 150 (FIG. 2). As shown in FIG. 4, in some embodiments, the sensor assembly 252 may omit the other components of embodiments of the sensor assemblies 100, 150 that are specifically configured to measuring or detecting electrical parameters, such as the piezoelectric devices 106, transformers 108, 112, etc.

Referring now to FIGS. 2 and 3, the canister 272 of the sensor assembly 250 may be positioned in or otherwise in contact with the transformer oil of the device 12 (FIG. 3) during operations. As a result of the thermal contact between the canister 272 and the transformer oil, the canister 272 and the chamber 274 defined therein may eventually have the same temperature as the transformer oil. As a result, FBG 104 may detect this temperature based on the resulting, characteristic strain that is applied to the FBG as previously described.

In some embodiments, the chamber 274 may be at least partially filled with a fluid that is configured to enhance the thermal heat transfer with the transformer oil at least partially surrounding the canister 272. For instance, in some embodiments, the chamber 274 may be at least partially filled with water, glycol, oil, other suitable fluids, or combinations thereof.

Referring specifically again to FIG. 3, the sensor assemblies 250, 252 may be communicatively coupled to the controller 30 and interrogator 22 via one or more fiber optic cables 262 as previously described. In some embodiments, each sensor assembly 250, 252 may be coupled to a corresponding fiber optic cable 262 that is routed into the subsea environment 5. In some embodiments, one or more of the fiber optic cables 262 may be at least partially routed into (or through) the subsea environment 5 in a cable bundle 260. In some embodiments, the cable bundle 260 may be a dedicated cable bundle for routing fiber optic cables 262 to the sensor assemblies 250, 252, or may be a cable bundle that includes or is associated with one or more other cables, lines, conduits that are routed through the subsea environment 5 for the system 200. For example, in some embodiments, one or more additional cables, such as electrical cables, fiber optic cables, or conduits, may be included in the bundle 260 that are configured to provide communication signals, power, fluid, etc. to one or more other components of the system 200, such as turbines 202, device 12, etc. Thus, in some embodiments, the fiber optic cables 262 for communicating with the sensor assemblies 250 ,252 may be at least partially integrated into other infrastructure (including fiber optic cabling) of the system 200.

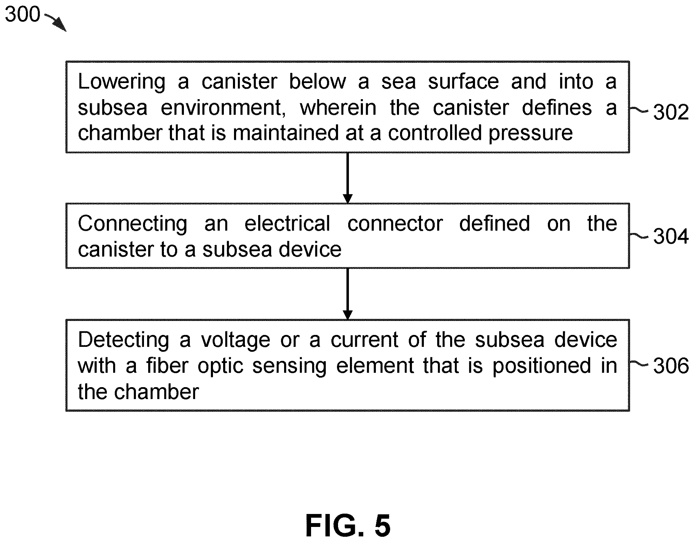

Referring now to FIG. 5, a method 300 of measuring one or more parameters by use of a subsea fiber optic sensor assembly is shown according to some embodiments disclosed herein. In some embodiments, the method 300 may be performed by use of one or more embodiments of the systems 10, 200 described herein. Thus, in describing the features of method 300, continuing reference is made to FIGS. 1-4. However, it should be appreciated that at least some embodiments of method 300 may be performed by use of systems that are different from the systems 10, 200 in at least some respects.

Method 300 includes lowering a canister below a sea surface and into a subsea environment at block 302. The canister defines a chamber that is maintained at a controlled pressure. For instance, as previously described for the sensor assembly 150 shown in FIG. 2, the canister 152 of sensor assembly 150 may be inserted int other subsea environment 5, and the canister 152 is configure to maintain a controlled pressure (such as about 1 atm as previously described) that may be different (such as less than) a pressure of the surrounding subsea environment 5.

In addition, method 300 includes connecting an electrical connector defined on the canister to a subsea device at block 304. For instance, as previously described for the sensor assembly 150 shown in FIG. 2, the canister 152 may include electrical connectors that are configured to connect the sensor assembly 100 to the electrical component(s) 14 of the subsea device 12. In some embodiments, the electrical connectors 158 may be included or incorporated into a bulkhead connector 159 that is configured to connect the canister 152 to the outer surface of the device 12 (or another structure, frame, housing, etc. associated with the device 12).

In some embodiments, the electrical connector (e.g., electrical connectors 158) may be connected to the electrical component(s) (e.g., electrical component(s) 14) of the subsea device (e.g., subsea device 12) before the canister is lowered below the sea surface, so that the canister and subsea device may be lowered below the sea surface together. Alternatively, in some embodiments, the electrical connector may be connected to the electrical component(s) of the subsea device after the canister is lowered subsea. For instance, as previously described for the sensor assembly 150 shown in FIG. 2, the electrical connectors 156 may comprise wet-mate connector that may be made up in the subsea environment 5. Thus, the canister 152 may be lowered into the subsea environment 5 and thereafter the electrical connectors 158 may be connected to the electrical component(s) 14, such as with a remotely operated or autonomous subsea vehicle, diver, etc.

Further, method 300 includes detecting a voltage or a current of the subsea device with a fiber optic sensing element that is positioned in the chamber at block 306. As previously described for the sensor assemblies 100, 150, shown in FIGS. 1, 2, respectively, a fiber optic sensing element 102 may detect a voltage or a current in the electrical component(s) 14 of the device 12 based on a strain that is induced onto one or more FBGs 104 defined on the fiber optic sensing element 102 by the voltage or current via piezoelectric devices 106. Thus, in some embodiments, a transformer (such as voltage transformer 112 or current transformer 108) may be coupled between the piezoelectric devices 106 and the electrical component(s) 14 in order to transmit an induced voltage or current to the corresponding piezoelectric devices 106 based on the voltage or current that is being measured or detected in the electrical component(s) 14.

In some embodiments, a subsea fiber optic sensor assembly (such as embodiments of the subsea fiber optic sensor assemblies 100, 150 described herein) may include multiple, redundant FBGs 104 for measuring one or more operating parameters of a subsea device. Without being limited to this or any other theory, the use of multiple, redundant FBGs 104 for measuring the same operating parameter(s) may allow the subsea fiber optic sensor assembly to continue to provide useful measurements in the event of a failure of one or more of the FBGs 104.

As explained above and reiterated below, the present disclosure includes, without limitation, the following Examples.

Example 1: A system comprising: a canister that defines a chamber and that is configured to maintain the chamber at a controlled pressure in a subsea environment; an electrical connector defined on the canister that is configured to be electrically coupled to a subsea device; and a fiber optic sensing element positioned in the chamber and coupled to the electrical connector such that the fiber optic sensing element is configured to detect a voltage or a current of the subsea device via the electrical connector.

Example 2: The system of any of the Examples, wherein the fiber optic sensing element includes a fiber Bragg grating (FBG).

Example 3: The system of any of the Examples, further comprising a piezoelectric device coupled between the electrical connector and the FBG of the fiber optic sensing element, wherein the piezoelectric device is configured to induce a strain on the FBG in response to the voltage or the current of the subsea device.

Example 4: The system of any of the Examples, wherein the FBG comprises a first FBG, the electrical connector comprises a first electrical connector, and the piezoelectric device comprises a first piezoelectric device, wherein the fiber optic sensing element includes a second FBG, and wherein the system further comprises: a second electrical connector defined on the canister that is configured to be coupled to the subsea device or another subsea device; and a second piezoelectric device that is coupled to the second electrical connector and the second FBG such that the second piezoelectric device is configured to induce a strain on the second FBG in response to a second voltage or a second current of the subsea device or the another subsea device.

Example 5: The system of any of the Examples, wherein the controlled pressure is less than a pressure of the subsea environment.

Example 6: The system of any of the Examples, wherein the controlled pressure of the chamber is about 1 atmosphere (atm).

Example 7: The system of any of the Examples, further comprising a controller that is communicatively coupled to the fiber optic sensing element, wherein the controller is configured to: output an interrogation signal to the fiber optic sensing element; receive a response reflection from the FBG via the fiber optic sensing element; and determine a value of the voltage or the current based on the response reflection.

Example 8: The system of any of the Examples, wherein the controller is at least partially positioned outside of the subsea environment, and the controller is coupled to the fiber optic sensing element via a fiber optic cable.

Example 9: The system of any of the Examples, wherein the subsea device comprises a subsea electrical transformer.

Example 10: The system of any of the Examples, further comprising: an offshore wind turbine that is configured to generate electrical power, and wherein the subsea electrical transformer is electrically coupled to the offshore wind turbine.

Example 11: The system of any of the Examples, wherein the electrical connector is incorporated into a bulkhead connector that is configured to connect the canister to an outer surface of the subsea electrical transformer.

Example 12: The system of any of the Examples, wherein the electrical connector is a wet-mate connector that is configured to be disconnected subsea to facilitate retrieval of the canister to a sea surface.

Example 13: The system of any of the Examples, wherein the subsea electrical transformer includes transformer oil, and wherein the system further comprises: a second canister that is thermally coupled to the transformer oil; and a second fiber optic sensing element positioned in the second canister that is configured to detect a temperature of the transformer oil.

Example 14: A method comprising: (a) lowering a canister below a sea surface and into a subsea environment, wherein the canister defines a chamber that is maintained at a controlled pressure; (b) connecting an electrical connector defined on the canister to a subsea device; and (c) detecting a voltage or a current of the subsea device with a fiber optic sensing element that is positioned in the chamber.

Example 15: The method of any of the Examples, wherein (b) is performed before (a).

Example 16: The method of any of the Examples, wherein (b) is performed after (a).

Example 17: The method of any of the Examples, wherein (c) comprises: (c1) actuating a piezoelectric device positioned in the canister by use of the voltage or the current of the subsea device; and (c2) inducing a strain on the fiber optic sensing element with the piezoelectric device that is characteristic of the voltage or the current.

Example 18: The method of any of the Examples, wherein (c2) further comprises inducing the strain on a fiber bragg grating (FBG) that is defined on the fiber optic sensing element.

Example 19: The method of any of the Examples, further comprising: (d) outputting an interrogation signal to the fiber optic sensing element; (e) receiving a response reflection from the FBG via the fiber optic sensing element; and (f) determining a value of the voltage or the current based at least in part on the response reflection.

Example 20: The method of any of the Examples, further comprising: (g) generating the interrogation signal by use of a controller that is at least partially positioned above the sea surface; and (h) conducting the interrogation signal from the controller to the canister via a fiber optic cable.

Example 21: The method of any of the Examples, wherein the subsea device comprises a subsea electrical transformer, and wherein the method further comprises: (i) generating electrical power with an offshore wind turbine; and (j) conducting the electrical power to the subsea electrical transformer, wherein the voltage or the current is at least partially indicative of the electrical power.

Example 22: The method of any of the Examples, further comprising: (k) detecting a temperature of a transformer oil in the subsea electrical transformer by use of a second fiber optic sensing element that is positioned in a second canister, the second canister being thermally coupled to the transformer oil.

Example 23: A system comprising: a canister that defines a chamber and that is configured to maintain the chamber at a controlled pressure in a subsea environment; one or more connectors defined on the canister that are configured to be coupled to a subsea device; and one or more fiber optic sensing elements positioned in the chamber and coupled to the one or more connectors such that the one or more fiber optic sensing elements are configured to detect a plurality of electrical parameters of the subsea device via the one or more connectors.

Example 24: The system of any of the Examples, wherein the one or more fiber optic sensing elements include a plurality of fiber bragg gratings (FBGs) that are coupled to the one or more connectors, and wherein each of the plurality of FBGs is configured to detect a corresponding electrical parameter of the plurality of electrical parameters via the one or more connectors.

Example 25: The system of any of the Examples, further comprising a plurality of piezoelectric devices that are positioned in the chamber and coupled to the plurality of FBGs such that each of the plurality of piezoelectric devices is configured to induce a strain on a corresponding FBG of the plurality of FBGs that is indicative of the corresponding electrical parameter for the corresponding FBG.

Example 26: The system of any of the Examples, further comprising a controller that is communicatively coupled to the one or more fiber optic sensing elements, wherein the controller is configured to: output interrogation signals to the one or more the fiber optic sensing elements; receive response reflections from the plurality of FBG via the one or more fiber optic sensing elements; and determine values of the plurality of electrical parameters based at least in part on the response reflections.

Example 27: The system of any of the Examples, wherein the one or more fiber optic sensing elements comprises a single fiber optic sensing element, wherein the plurality of FBGs are positioned along the single fiber optic sensing element within the chamber, and wherein the controller is configured to output a first interrogation signal having a first wavelength to a first of the plurality of FBGs via the single fiber optic sensing element and is configured to output a second interrogation signal having a second wavelength to a second of the plurality of FBGs via the single fiber optic sensing element.

Example 28: The system of any of the Examples, wherein the plurality of electrical parameters comprises one or more voltages or currents of the subsea device.

Example 29: The system of any of the Examples, further comprising: an offshore wind turbine that is configured to generate electrical power, and wherein the subsea device comprises a subsea electrical transformer that is electrically coupled to the offshore wind turbine.

Example 30: The system of any of the Examples, wherein the subsea electrical transformer includes transformer oil, and wherein the system further comprises: a second canister that is thermally coupled to the transformer oil; and a second fiber optic sensing element positioned in the second canister that is configured to detect a temperature of the transformer oil.

Embodiments disclosed herein are directed to subsea fiber optic sensor assemblies that are configured to passively measure or detect one or more operating parameters of a subsea device during operations. In some embodiments, the fiber optic sensors assemblies may be configured to measure the one or more operating parameters of the subsea device by use of light signals and reflections thereof. In some embodiments, the fiber optic measurement assemblies may include one or more FBGs that are configured to sense the one or more operating parameters. However, such FBGs may be sensitive to environmental forces that change a distance between the gratings (such as pressure, strain, temperature, etc.). Accordingly, embodiments of the subsea fiber optic sensors assemblies disclosed herein may be configured to account for the effects of such environmental forces so that accurate measurements may be obtained during operations. Thus, through use of the embodiments disclosed herein, one or more operating parameters of a subsea device may be accurately and passively measured during operations..

The preceding discussion is directed to various embodiments. However, one of ordinary skill in the art will understand that the examples disclosed herein have broad application, and that the discussion of any embodiment is meant only to be exemplary of that embodiment, and not intended to suggest that the scope of the disclosure, including the claims, is limited to that embodiment.

The drawing figures are not necessarily to scale. Certain features and components herein may be shown exaggerated in scale or in somewhat schematic form and some details of conventional elements may not be shown in interest of clarity and conciseness.

In the preceding discussion and in the claims, the terms "including" and "comprising" are used in an open-ended fashion, and thus should be interpreted to mean "including, but not limited to . . . ." Also, the term "couple" or "couples" is intended to mean either an indirect or direct connection. Thus, if a first device couples to a second device, that connection may be through a direct connection of the two devices, or through an indirect connection that is established via other devices, components, nodes, and connections. In addition, as used herein, the terms "axial" and "axially" generally mean along or parallel to a given axis (e.g., central axis of a body or a port), while the terms "radial" and "radially" generally mean perpendicular to the given axis. For instance, an axial distance refers to a distance measured along or parallel to the axis, and a radial distance means a distance measured perpendicular to the axis. Further, when used herein (including in the claims), the words "about," "generally," "substantially," "approximately," and the like, when used to refer to a stated value, mean within a range of plus or minus 10% of the stated value.

While exemplary embodiments have been shown and described, modifications thereof can be made by one skilled in the art without departing from the scope or teachings herein. The embodiments described herein are exemplary only and are not limiting. Many variations and modifications of the systems, apparatus, and processes described herein are possible and are within the scope of the disclosure. Accordingly, the scope of protection is not limited to the embodiments described herein, but is only limited by the claims that follow, the scope of which shall include all equivalents of the subject matter of the claims. Unless expressly stated otherwise, the steps in a method claim may be performed in any order. The recitation of identifiers such as (a), (b), (c) or (1), (2), (3) before steps in a method claim are not intended to and do not specify a particular order to the steps, but rather are used to simplify subsequent reference to such steps.

## Claims

1. A system comprising:
a canister that defines a chamber and that is configured to maintain the chamber at a controlled pressure in a subsea environment;
an electrical connector defined on the canister that is configured to be electrically coupled to a subsea device; and
a fiber optic sensing element positioned in the chamber and coupled to the electrical connector such that the fiber optic sensing element is configured to detect a voltage or a current of the subsea device via the electrical connector.

2. The system of claim 1, wherein the fiber optic sensing element includes a fiber Bragg grating (FBG), and the system further comprises a piezoelectric device coupled between the electrical connector and the FBG of the fiber optic sensing element, where the piezoelectric device is configured to induce a strain on the FBG in response to the voltage or the current of the subsea device.

3. The system of claim 2,
wherein the FBG comprises a first FBG, the electrical connector comprises a first electrical connector, and the piezoelectric device comprises a first piezoelectric device;
wherein the fiber optic sensing element includes a second FBG;
wherein the system further comprises:
a second electrical connector defined on the canister that is configured to be coupled to the subsea device or another subsea device; and
a second piezoelectric device that is coupled to the second electrical connector and the second FBG such that the second piezoelectric device is configured to induce a strain on the second FBG in response to a second voltage or a second current of the subsea device or the another subsea device.

4. The system of claim 2 or 3,
wherein the controlled pressure is less than a pressure of the subsea environment, the controlled pressure of the chamber is about 1 atmosphere (atm), and the system further comprises a controller that is communicatively coupled to the fiber optic sensing element;
wherein the controller is configured to:
output an interrogation signal to the fiber optic sensing element;
receive a response reflection from the FBG via the fiber optic sensing element; and
determine a value of the voltage or the current based on the response reflection;
wherein the controller is at least partially positioned outside of the subsea environment, and the controller is coupled to the fiber optic sensing element via a fiber optic cable.

5. The system of any one of the preceding claims, further comprising:
an offshore wind turbine that is configured to generate electrical power;
wherein the subsea device comprises a subsea electrical transformer;
wherein the subsea electrical transformer is electrically coupled to the offshore wind turbine;
wherein the subsea electrical transformer includes transformer oil;
wherein the system further comprises:
a second canister that is thermally coupled to the transformer oil; and
a second fiber optic sensing element positioned in the second canister that is configured to detect a temperature of the transformer oil.

6. The system of claim 5, wherein the electrical connector is incorporated into a bulkhead connector that is configured to connect the canister to an outer surface of the subsea electrical transformer.

7. The system of claim 5 or 6, wherein the electrical connector is a wet-mate connector that is configured to be disconnected subsea to facilitate retrieval of the canister to a sea surface.

8. A method comprising:
(a) lowering a canister below a sea surface and into a subsea environment, where the canister defines a chamber that is maintained at a controlled pressure;
(b) connecting an electrical connector defined on the canister to a subsea device; and
(c) detecting a voltage or a current of the subsea device with a fiber optic sensing element that is positioned in the chamber.

9. The method of claim 8, wherein (b) is performed before (a).

10. The method of claim 8 or 9, wherein the subsea device comprises a subsea electrical transformer, and (c) comprises:
(c1) actuating a piezoelectric device positioned in the canister by use of the voltage or the current of the subsea device; and
(c2) inducing a strain on a fiber Bragg grating (FBG) that is defined on the fiber optic sensing element with the piezoelectric device that is characteristic of the voltage or the current;
wherein the method further comprises:
(d) outputting an interrogation signal to the fiber optic sensing element;
(e) receiving a response reflection from the FBG via the fiber optic sensing element;
(f) determining a value of the voltage or the current based at least in part on the response reflection;
(g) generating the interrogation signal by use of a controller that is at least partially positioned above the sea surface;
(h) conducting the interrogation signal from the controller to the canister via a fiber optic cable;
(i) generating electrical power with an offshore wind turbine;
(j) conducting the electrical power to the subsea electrical transformer, where the voltage or the current is at least partially indicative of the electrical power; and
(k) detecting a temperature of a transformer oil in the subsea electrical transformer by use of a second fiber optic sensing element that is positioned in a second canister, the second canister being thermally coupled to the transformer oil.

11. A system comprising:
a canister that defines a chamber and that is configured to maintain the chamber at a controlled pressure in a subsea environment;
one or more connectors defined on the canister that are configured to be coupled to a subsea device; and
one or more fiber optic sensing elements positioned in the chamber and coupled to the one or more connectors such that the one or more fiber optic sensing elements are configured to detect a plurality of electrical parameters of the subsea device via the one or more connectors.

12. The system of claim 11,
wherein the one or more fiber optic sensing elements include a plurality of fiber Bragg gratings (FBGs) that are coupled to the one or more connectors, and each of the plurality of FBGs is configured to detect a corresponding electrical parameter of the plurality of electrical parameters via the one or more connectors;
wherein the system further comprises a plurality of piezoelectric devices that are positioned in the chamber and coupled to the plurality of FBGs such that each of the plurality of piezoelectric devices is configured to induce a strain on a corresponding FBG of the plurality of FBGs that is indicative of the corresponding electrical parameter for the corresponding FBG.

13. The system of claim 12, further comprising:
a controller that is communicatively coupled to the one or more fiber optic sensing elements;
wherein the controller is configured to:
output interrogation signals to the one or more the fiber optic sensing elements;
receive response reflections from the plurality of FBG via the one or more fiber optic sensing elements; and
determine values of the plurality of electrical parameters based at least in part on the response reflections;
wherein the one or more fiber optic sensing elements comprises a single fiber optic sensing element, and the plurality of FBGs are positioned along the single fiber optic sensing element within the chamber;
wherein the controller is configured to output a first interrogation signal having a first wavelength to a first of the plurality of FBGs via the single fiber optic sensing element and is configured to output a second interrogation signal having a second wavelength to a second of the plurality of FBGs via the single fiber optic sensing element.

14. The system of claim 12 or 13, wherein the plurality of electrical parameters comprises one or more voltages or currents of the subsea device.

15. The system of claim 12, 13 or 14, further comprising:
an offshore wind turbine that is configured to generate electrical power;
wherein the subsea device comprises a subsea electrical transformer that is electrically coupled to the offshore wind turbine;
wherein the subsea electrical transformer includes transformer oil;
wherein the system further comprises:
a second canister that is thermally coupled to the transformer oil; and
a second fiber optic sensing element positioned in the second canister that is configured to detect a temperature of the transformer oil.
